# EUROPEAN PATENT APPLICATION

(11) **EP 1 378 346 A1**
(43) Date of publication of application: **07.01.2004**
(21) Application number: 02710506.3
(22) Date of filing: 05.02.2002
(51) Int. Cl.: B32B 15/08, H05K 3/46

(54) **HIGH POLYMER PLATE AND CONDUCTIVE PLATE CONNECTING BODY, AND PART USING THE CONNECTING PLATE**

(30) Priority: 16.03.2001 JP 2001077143
(71) Applicant: Toyo Kohan Co., Ltd., Tokyo 102-8447 (JP)
(72) Inventor: SAIJO, K., c/o TOYO KOHAN CO. LTD, Kudamatsu-shi, Yamaguchi 744-8611 (JP); YOSHIDA, K., c/o TOYO KOHAN CO. LTD, Kudamatsu-shi, Yamaguchi 744-8611 (JP); OKAMOTO, H., c/o TOYO KOHAN CO. LTD, Kudamatsu-shi, Yamaguchi 744-8611 (JP); OHSAWA, S., c/o TOYO KOHAN CO. LTD, Kudamatsu-shi, Yamaguchi 744-8611 (JP)
(74) Representative: VOSSIUS & PARTNER
(86) International application number: PCT/JP2002/000928
(87) International publication number: WO 2002/074531

(57) **Abstract**

A high polymer plate and conductive plate connecting body formed by connecting a high polymer plate to a conductive plate without using an adhesive agent and a part using the high polymer plate and conductive plate connecting body; the connecting body, wherein the faces of the high polymer plate and the conductive plate opposed to each other are connected to each other after the plates receive an activation under an extremely low pressure; a part.

## Description

High polymer plate and conductive plate connecting body and a part using the high polymer plate and conductive plate connecting body

### Technical Field

The present invention concerns a high polymer plate and conductive plate connecting body formed by connecting a high polymer plate and a conductive plate without using an adhesive, as well as a part using the high polymer plate and conductive plate connecting body.

### Background Art

Heretofore, various laminates have been proposed in which conductive plates such as a metal thin film is laminated on a high polymer plate such as a film. For example, those in which a metal thin film is formed on a heat resistant film typically represented by polyethylene terephthalate or polyimide are excellent in mechanical, electrical and thermal characteristics and are used, for example, in flexible circuit substrates.

As a method of laminating a metal foil to a film, various methods of forming a metal thin film directly on the film have been proposed in addition to the method of connecting the metal film and the film by using adhesives. For example, in JP-A No. 11-207866, a metal thin film of 1 µm or less is formed on a film by a thin film forming method such as ion plating or sputtering and, further, the thickness of the film is increased by a method such as electric plating in a case where thickness of 1 µm or more is necessary.

However, the existent lamination method described above was troublesome in that plural different production processes had to be used together in a case where relatively large thickness was required for a conductor portion such as metal or involved problems in view of the time required for production and production cost.

In view of the technical background described above, the invention has a subject of providing a connecting body of a high polymer plate and a conductive plate formed by connecting a conductive plate having a required thickness on a high polymer plate without using an adhesive, parts using the connecting body of the high polymer plate and the conductive plate, that is, printed wiring boards, IC (Integrated Circuit) packages and heat dissipation plates.

### Disclosure of the Invention

A high polymer conductive plate connecting body described in claim 1 is a connecting body in which a conductive plate is laminated on one or both surfaces of a high polymer plate, wherein the surface of each of the high polymer plate and the conductive plate to be connected is previously applied with an activation treatment in a vacuum chamber and then they are abutted to stack such that the activated surfaces of the high polymer plate and the conductive plate are opposed to each other and then applied with cold press bonding. For the activation treatment, it is preferred to conduct glow discharge in an inert gas atmosphere and apply a sputter etching treatment to each of the surfaces of the high polymer plate and the conductive plate.

A part described in claim 3 uses a high polymer plate and conductive plate connecting body and it is preferably applied, for example, to a printed wiring board, IC package and heat dissipation plate.

### Brief Description of the Drawings

Fig. 1 is a schematic cross sectional view showing an embodiment of a high polymer plate and conductive plate connecting body according to the invention.
Fig. 2 is a schematic cross sectional view showing another embodiment of a high polymer plate and conductive plate connecting body according to the invention.
Fig. 3 is a schematic view of an apparatus for producing a high polymer plate and conductive plate connecting body used in the invention.

### Best Mode for Carrying Out the Invention

Embodiments of the invention are to be described later.

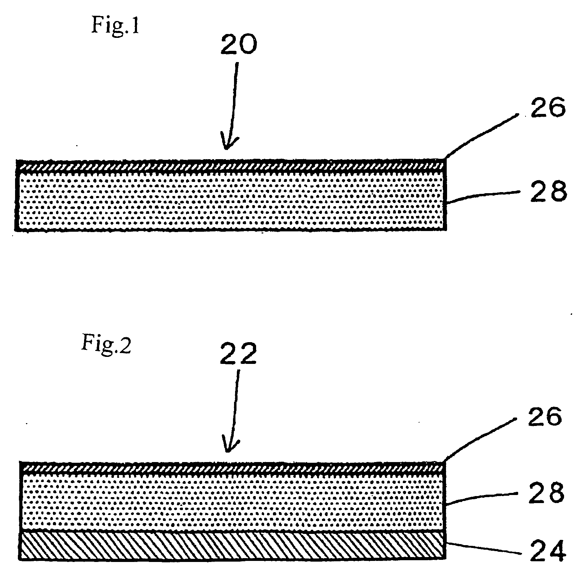

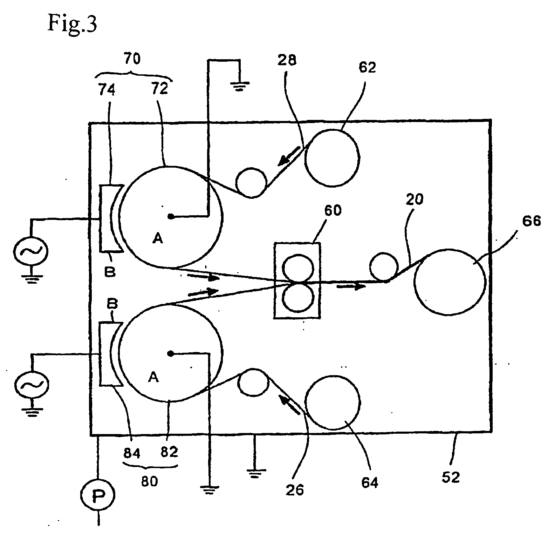

Fig. 1 is a schematic cross sectional view showing an embodiment of a high polymer plate and conductive plate connecting body according to the invention which shows an example of laminating a conductive plate 26 on one surface of a high polymer plate 28. Fig. 2 is a schematic cross sectional view showing another embodiment, which shows the example of laminating conductive plates 24 and 26 on both surfaces of a high polymer plate 28. Fig. 3 is a schematic cross sectional view of an apparatus for use in the production of a connecting body of a high polymer plate and a conductive plate of the invention.

In the high polymer plate and conductive plate connecting body 20 shown in Fig. 1, a conductive plate 26 and a high polymer plate 28 are laminated. Further, in a high polymer plate and conductive plate connecting body 22 shown in Fig. 2, a conductive plate 26, a high polymer plate 28 and a conductive plate 24 are laminated.

The material for the high polymer plate 28 has no particular restriction on the kind thereof so long as it is a material capable of producing a high polymer plate and conductive plate connecting body, and can be properly selected and used depending on the application use of the high polymer plate and conductive plate connecting body. For example, organic high polymer materials such as plastics and mixtures formed by mixing fibers to plastics are applied. In a case of applying the high polymer plate and conductive plate connecting body to a flexible printed substrate or the like, polyimide, polyether imide, polyester such as polyethylene terephthalate and aromatic polyamide such as nylon are used.

As the plastics used for the high polymer plate, those applicable include, for example, acrylo resin, amino resin (such as melamine resin, urea resin and benzoguanamine resin), allyl resin, alkyd resin, urethane resin, liquid crystal polymer, EEA resin (Ethylene Ethylacrylate resin, random copolymer resin ethylene and ethyl acrylate), AAS resin (Acrylonitrile Acrylate Styrene resin), ABS resin (acrylonitrile Butadiene Styrene resin, resin comprising combination of acrylonitrile, butadiene and styrene), ACS resin (acrylonitrile Chlorinated Polyethylene Styrene resin), AS resin (Acrylonitrile Styrene resin, styrene - acrylonitrile copolymer resin), ionomer resin, ethylene polytetrafluoro ethylene copolymer, epoxy resin, silicon resin, styrene butadiene resin, phenol resin, fluoro ethylene propylene, fluoro resin, polyacetal, polyallylate, polyamide (such as 6 nylon, 11 nylon, 12 nylon, 66 nylon, 610 nylon and 612 nylon), polyamide imide, polyimide, polyether imide, polyether ether ketone, polyether sulfone, polyester (such as polyethylene terephthalate, polybutylene terephthalate, polyethylene naphthalate, polycyclohexne dimel terephthalate, polytrimethylene terephthalate, and poly trimethylene naphthalate, etc.) polyolefin (such as polyethylene and polypropylene), polycarbonate, polychloro trifluoro ethylene, polysulfone, polystyrene, polyphenylene sulfide, polybutadiene, polybutene, and polymethylpentene.

Further, the thickness of the high polymer plate 28 is properly selected depending on the application use of the high polymer plate and conductive plate connecting body. For example, it is 1 to 1000 µm. In a case where it is less than 1 µm, production as a high polymer plate is difficult. In a case where it exceeds 1000 µm, production as a connecting body is difficult. In a case where the application use of the high polymer plate and conductive plate connecting body is a flexible printed substrate, those within a range, for example, of 3 to 300 µm are applied. In a case where it is less than 3 µm, mechanical strength is poor. In a case where it exceeds 300 µm, the flexibility is poor. It is preferably from 10 to 150 µm and, more preferably, from 20 to 75 µm.

The material for the conductive plate 26 has no particular restriction on the kind thereof so long as it is a material capable of producing the high polymer plate and conductive plate connecting body and it can be properly selected and used depending on the application use of the high polymer plate and conductive plate connecting body. For example, a metal which is solid at a normal temperature (for example, Al, Ni, Cu, Ag, Pt and Au), an alloy containing at least one of the metals (for example, alloy according to JIS), or a laminate having at least one of the metals and the alloys described above (for example, clad material, plated material and vapor deposited film material) are applied. In a case where the application use of the high polymer plate and conductive plate connecting body is a flexible printed substrate, Cu, Al, Ni or Ag which is a metal of excellent conductivity, an alloy containing at least one of the metals described above or a laminate having at least one layer of the metals or alloys thereof are applied.

As the alloys according to JIS, plates or foils, for example of Cu series alloys such as oxygen free high conductive copper, tough pitch copper, phosphorus deoxidized copper, red brass, brass, free cutting brass, tin brass, admiralty brass, Neval brass, aluminum bronze, and cupro nickel described, for example, in JIS H 3100, JIS H 3110 or JIS H 3130, and Al series alloys having alloy Nos. of 1000 series, 2000 series, 3000 series, 5000 series, 6000 series and 7000 series described, for example, in JIS H 4000 or JIS H 4160 are applied. As the Ni series alloy, ordinary carbon nickel, low carbon nickel, nickel-copper alloys, nickel-copper-aluminum-titanium alloy, nickel-molybdenum alloy, nickel-molybdenum-chromium alloy, nickel-chromium-iron-molybdenum-copper alloy, and nickel-chromium-molybdenum-iron alloy can be applied.

The thickness of the conductive plate 26 is also selected properly depending on the application use of the high polymer plate and conductive plate connecting body. For example, it is 1 to 1000 µm. In a case where it is less than 1 µm, production as the conductive plate is difficult. In a case where it exceeds 1000 µm, production as the connecting body is difficult. In a case where the application use of the high polymer plate and conductive plate connecting body is a flexible printed substrate, those of relatively thin thickness are applied. It is, for example, from 1 to 150 µm. In a case where it is less than 1 µm, conductivity is poor. In a case where it exceeds 150 µm, flexibility is poor. It is preferably from 3 to 100 µm, more preferably, from 10 to 30 µm. In a case where the application use of the high polymer plate and conductive plate connecting body is a heat dissipation plate or chassis, those of larger thickness are applied. For example, it is from 30 to 1000 µm. In a case where it is less than 30 µm, mechanical strength is poor. In a case where it exceeds 1000 µm, it is too heavy. Preferably, it is 50 to 500 µm.

The material for the conductive plate 24 has no particular restriction so long as it is a material applicable to the conductive plate 26 and it may be a material identical with or different from that of the conductive plate 26. Further, the thickness for the conductive plate 24 may be identical with or different from that of the conductive plate 26.

Description is to be made to a method of manufacturing a high polymer plate and conductive plate connecting body shown in Fig. 1. As shown in Fig. 3, a high polymer plate 28 placed on an unwinding reel 62 is applied with an activation treatment by an activation treatment device 70 in a vacuum chamber 52. In the same manner, a conductive plate 26 placed on an unwinding reel 64 is applied with an activation treatment by an activation treatment device 80.

The activation treatment is conducted as described below. That is, the high polymer plate 28 and the conductive plate 26 loaded in a vacuum chamber 52 are brought into contact, respectively, with one electrode A grounded to the earth, glow discharge is conducted by applying an alternating current at 1 to 50 MHz between the electrode A and the other electrode B supported under insulation in an extremely low pressure inert gas atmosphere, preferably, in an argon gas at 10 to 1 x 10⁻³ Pa, and a sputter etching treatment is applied such that each of the areas of the high polymer plate 28 and the conductive plate 26 in contact with the electrode A exposed in plasmas generated by glow discharge is 1/3 or less of the area for the electrode B. In a case where the pressure of the inert gas is lower than 1 x 10⁻³ Pa, it is difficult to conduct stable glow discharge, making it difficult for high speed etching. In a case where it exceeds 10 Pa, the activation treatment efficiency is lowered. In a case where the applied alternating current is lower than 1 MHz, it is difficult to keep stable glow discharge and continuous etching is difficult. In a case where it exceeds 50 MHz, oscillation tends to occur, making the power supply system complicated, which is not preferred. Further, for efficient etching, it is necessary to decrease the area for the electrode A smaller than the area for the electrode B and etching is possible at a sufficient efficiency by setting it to 1/3 or less.

Then, the high molecular plate 28 and the conductive plate 26 applied with the activation treatment are stacked such that both of them are abutted with the activated surfaces being opposed to each other and connected by cold press bonding by a press bonding unit 60. The connection in this case can be conducted at low temperature • low rolling reduction ratio, and undesired effects such as change or fracture in the texture of the high polymer plate and the conductive plate by connection can be moderated or eliminated. In the case of using the method of the invention, a favorable press bonding state can be attained at: 0 < T ≤ 300, 0.1 ≤ R ≤ 30 where T represents temperature (°C) of the high polymer plate and conductive plate and R represents rolling reduction ratio (%). Below 0°C, a special refrigeration system is required. In a case where it exceeds 300°C, undesired effect such as change of texture is caused. Further, at a rolling reduction ratio of less than 0.1%, no sufficient connection strength is obtained. In a case where it exceeds 30%, undesired effect such as fracture is caused. It is, more preferably, 0.5 ≤ R ≤ 10.

By the connection described above, a high polymer plate and conductive plate connecting body 20 is formed and taken up by a winding roll 66. In this way, a high polymer plate and conductive plate connecting body 20 shown in Fig. 1 is produced.

Then, a high polymer plate and conductive plate connecting body shown in Fig. 2 is produced in the same manner as described above except for using a high polymer plate and conductive plate connecting body 20 having a conductive plate on one surface instead of the high polymer plate 28 and using a conductive plate 24 instead of the conductive plate 26.

The high polymer plate and conductive plate connecting body prepared as described above may optionally be applied with a heat treatment for removing or decreasing the residual stress in the conductive plate. For example, in a case where the conductive plate comprises copper, a sufficient decrease of the residual stress can be attained at about 250 to 300°C x 1h. In the heat treatment, since a toxic gas which may cause lowering of the connection strength (for example, oxygen) may possibly permeate through the high molecular plate, it is preferably carried under vacuum, or under a reduced pressure or in a reducing atmosphere.

In a case where the thickness and the hardness of the high polymer plate or the conductor are not suitable to the production using the roll, batchwise treatment may be used. It is attained by loading a plurality of high polymer plates and conductive plates each previously cut into a predetermined size in a vacuum chamber, conveying them to an activation treatment station, conducting an activation treatment while fixing them by placing or gripping in a state where surfaces to be treated are opposed to each other or set in parallel with each other at an appropriate position such as vertically or horizontally, further press bonding them while placing or gripping them after the activation treatment in a case where a holding device station for the high polymer plates and the conductive plates also serve as the press bonding device, or press bonding them by conveying to a press bonding device such as a press in a case where the holding device station for the high polymer plates and the conductive plates do not serve as the press bonding device.

Further, the high polymer plate and conductive plate connecting body is cut out into an appropriate size as required and etching fabrication or the like is applied to the conductive plate of the high polymer plate and conductive plate connecting body to form a circuit pattern thereby obtaining a circuit substrate. Therefore, it can be applied, for example, to a printed wiring board (such as rigid printed wiring board or flexible printed wiring board), and also to an IC package such as an IC card, CSP (chip size package or chip scale package) or BGA (ball grid array). Particularly, in a high polymer plate and conductive plate connecting body having conductive plates on both surfaces, more complicate circuits can be formed by applying fabrication such as forming through holes thereby ensuring conduction between both of the surfaces by using an appropriate method such as plating.

The high polymer plate and conductive plate connecting body having conductive plates on both surfaces can be used as a chassis by applying circuit wirings on one surface and using the other surface as a shielding plate for electrostatic shielding, or can be utilized as a heat dissipation plate or ground. Further, it is also possible to use the high polymer plate and conductive plate connecting body itself having the conductive plate on one surface as the shield plate for electrostatic shielding or can be used as a chassis or utilized as a heat dissipation plate or a ground. Further, machining such as bending fabrication may also be applied to the high polymer plate and conductive plate connecting body as required.

### Example

Examples are to be described with reference to the drawings.

### (Example 1)

A polyimide film of 50 µm thickness was used as the high polymer plate 28, while a copper foil of 35 µm thickness was used as the conductive plate 26. The polyimide film and the copper foil were set to the high polymer plate and conductive plate connecting body production apparatus, the polyimide film unwound from the unwinding reel 62 and the copper foil unwound from the unwinding reel 64 were wound around water cooled electrode rolls 72, 82, respectively, and they were applied with an activation treatment by sputter etching in the activation treatment units 70, 80 respectively. Then, the polyimide film and the copper foil applied with the activation treatment were stacked with the activated surfaces being abutted with each other by the press bonding unit 60, cold press bonded at a rolling reduction ratio of 0.5% and wound up to the winding roll 66 to manufacture a high polymer plate and conductive plate connecting body 20.

### (Example 2)

A liquid crystal polymer film of 50 µm thickness was used as the high polymer plate 28, while a copper foil of 35 µm thickness (JIS H 3100 alloy No. C1020, oxygen free high conductive copper) was used as the conductive plate 26. The liquid crystal polymer film and the copper foil were set to the high polymer plate and conductive plate connecting body production apparatus, the liquid crystal polymer film unwound from the unwinding reel 62 and the copper foil unwound from the unwinding reel 64 were wound around water cooled electrode rolls 72, 82 in the vacuum chamber 52, respectively, and they were applied with an activation treatment by sputter etching in the activation treatment units 70, 80, respectively. Then, the liquid crystal polymer film and the copper foil applied with the activation treatment were stacked with the activated surfaces being abutted with each other by the press bonding unit 60, cold press bonded at a rolling reduction ratio of 3% and wound up to the winding roll 66 to manufacture a high polymer plate and conductive plate connecting body 20.

### (Example 3)

A polyester film film of 20 µm thickness was used as the high polymer plate 28, while a copper foil of 35 µm thickness (JIS H 3100 alloy No. C1020, oxygen free high conductive copper) was used as the conductive plate 26. The polyester film and the copper foil were set to the high polymer plate and conductive plate connecting body production apparatus, the polyester film unwound from the unwinding reel 62 and the copper foil unwound from the unwinding reel 64 were wound around water cooled electrode rolls 72, 82 in the vacuum chamber 52, respectively, and they were applied with an activation treatment by sputter etching in the activation treatment units 70, 80, respectively. Then, the polyester film and the copper foil applied with the activation treatment were stacked with the activated surfaces being abutted with each other by the press bonding unit 60, cold press bonded at a rolling reduction ratio of 1% and wound up to the winding roll 66 to manufacture a high polymer plate and conductive plate connecting body 20.

### (Example 4)

A liquid crystal polymer film of 50 µm thickness was used as the high polymer plate 28, while an aluminum foil of 30 µm thickness (JIS H 4160 alloy No. 1085) was used as the conductive plate 26. The liquid crystal polymer film and the copper foil were set to the high polymer plate and conductive plate connecting body production apparatus, the liquid crystal polymer film unwound from the unwinding reel 62 and the copper foil unwound from the unwinding reel 64 were wound around water cooled electrode rolls 72, 82 in the vacuum chamber 52, respectively; and they were applied with an activation treatment by sputter etching in the activation treatment units 70, 80, respectively. Then, the liquid crystal polymer film and the copper foil applied with the activation treatment were stacked with the activated surfaces being abutted with each other by the press bonding unit 60, cold press bonded at a rolling reduction ratio of 2% and wound up to the winding roll 66 to manufacture a high polymer conductive plate connecting body 20.

### Industrial Applicability

As has been described above, the high polymer plate and conductive plate connecting body according to the invention is formed by applying an activation treatment to the surfaces of the high polymer plate and the conductive plate opposed to each other and then cold press bonding them at a low rolling reduction ratio by stacking the activated surfaces to each other such that they are abutted against each other. Accordingly, the adhesive is not used, further weight reduction or decrease of thickness can be attained and it can be suitably applied, for example, to an IC package or heat dissipation plate. Furthermore, since a conductive plate of a required thickness can be used, the steps are simplified and the production cost can be suppressed.

## Claims

1. A high polymer plate and conductive plate connecting body which is a connecting body formed by laminating a conductive plate to one surface or both surfaces of a high polymer plate wherein the connection is conducted by previously applying an activated treatment to each of the surfaces of the high polymer plate and the conductive plate, respectively, in a vacuum chamber, and then conducting cold press bonding while abutting to stack the high polymer plate and the conductive plate such that the activated surfaces thereof are opposed to each other.

2. A high polymer plate and conductive plate connecting body according to claim 1, wherein the activation treatment comprises conducting glow discharge in an inert gas atmosphere and sputter etching each of the surfaces of the high polymer plate and the conductive plate, respectively.

3. A part using the high polymer plate and conductive plate connecting body as described in claim 1 or 2.

4. A part according to claim 3 wherein the part is a printed wiring board.

5. A part according to claim 3 wherein the part is an IC package.

6. A part according to claim 3 wherein the part is a heat dissipation plate.
